# DEMANDE DE BREVET EUROPEEN

(11) **EP 0 957 449 A1**
(43) Date de publication de la demande: **17.11.1999**
(21) Numéro de dépôt: 99401055.1
(22) Date de dépôt: 29.04.1999
(51) Int. Cl.: G06K 19/077, H01L 21/60, H01L 21/56, H01L 23/498

(54) **Carte a memoire du type sans contact, et procede de fabrication d'une telle carte**

(30) Priorité: 11.05.1998 FR 9805888
(71) Demandeur: SCHLUMBERGER Systèmes, 92120 Montrouge (FR)
(72) Inventeur: Mande, Mickael, 45100 Orleans (FR)

(57) **Abrégé**

L'invention concerne une carte à mémoire du type sans contact, comportant un corps de carte laminé en matière plastique (1) incluant une feuille de support (1.2) sur laquelle est agencée une antenne de couplage (5) ainsi qu'un circuit intégré (7) relié à ladite antenne.

Conformément à l'invention, le circuit intégré (7) repose directement par deux plots de contact sur deux plages conductrices (3) connectées à l'antenne de couplage (5), en étant également en appui sur deux plages de compensation non connectées (4). Le circuit intégré (7) et la feuille de support (1.2) sont en outre associés mécaniquement l'un à l'autre par un matériau adhésif (11, 12) agencé dans l'espace libre délimité par leurs faces respectives en regard.

## Description

La présente invention concerne le domaine des cartes à mémoire du type sans contact. De telles cartes sont couramment utilisées pour constituer par exemple des badges ou des cartes de péage à distance.

Les carte à mémoire sans contact comportent habituellement un circuit intégré et une antenne de couplage associée, tous deux noyés dans un ensemble plat isolant. Dans la pratique, l'antenne est organisée selon un motif spiralé, dont les deux extrémités sont reliées à deux plots de contact du circuit intégré.

Le document EP-A-0 671 705 illustre une carte sans contact dont le corps de carte présente une cavité laissant apparaître les bornes de contact de l'antenne de couplage, cavité dans laquelle est inséré un module électronique comprenant un circuit intégré et deux plages de contact.

Un tel type de carte sans contact présente l'inconvénient de devoir ménager une cavité dans le corps de carte, et de mettre en place de façon aussi précise que possible un module électronique dans la cavité associée de chaque corps de carte. Un tel processus est difficilement compatible avec une fabrication en grande série des cartes sans contact.

L'invention concerne plus particulièrement une carte à mémoire sans contact du type comportant un corps de carte laminé en matière plastique présentant une feuille de support prise en sandwich, sur une face de laquelle est agencée une antenne de couplage et un circuit intégré dont les deux plots de contact sont reliés à ladite antenne de couplage.

Le document EP-A-0 737 935 illustre une carte sans contact de ce type. Le circuit intégré de la carte sans contact décrite dans ce document est associé à l'antenne de couplage par l'intermédiaire d'une couche de matériau adhésif conducteur anisotrope d'environ 10 à 50 µm d'épaisseur. Les plots de contact du circuit intégré sont alors noyés dans cette couche conductrice anisotrope adhésive. La liaison mécanique entre le circuit intégré et la feuille isolante de support peut toutefois s'avérer insuffisamment forte, dans la mesure où la couche adhésive ne s'accroche que sur les faces supérieures des spires de l'antenne de couplage. Par suite, la tenue mécanique du circuit intégré sur les plages de l'antenne de couplage peut s'avérer insuffisante en cas d'efforts de flexion et/ou de torsion imprimés au corps de carte laminé de la carte à mémoire sans contact terminée.

On pourra également se référer aux documents DE-A-44 31 605 et EP-A-0 682 321 qui illustrent d'autres modes d'exécution analogues.

L'invention vise précisément à résoudre ce problème technique, en concevant une carte à mémoire sans contact à corps de carte laminé en matière plastique, présentant une meilleure tenue mécanique du circuit intégré contre les plages de l'antenne de couplage, même en cas d'efforts de flexion et de torsion importants.

L'invention vise également à concevoir une carte à mémoire du type sans contact dont la structure soit compatible avec la réalisation d'une antenne de couplage par sérigraphie sur la feuille de support associée.

Ce problème est résolu conformément à l'invention grâce à une carte à mémoire du type sans contact, comportant un corps de carte laminé en matière plastique présentant une feuille de support prise en sandwich, sur une face de laquelle est agencée une antenne de couplage ainsi qu'un circuit intégré dont deux plots de contact sont reliés à ladite antenne de couplage, le circuit intégré reposant directement par les deux plots précités sur deux plages conductrices connectées à l'antenne de couplage, en étant également en appui sur au moins une plage supplémentaire de compensation non connectée à ladite antenne, de façon à s'étendre sensiblement parallèlement à la feuille de support, ledit circuit intégré et ladite feuille de support étant associés mécaniquement l'un à l'autre par un matériau adhésif agencé dans l'espace libre délimité par leurs faces respectives en regard.

Le matériau adhésif présent dans l'espace libre délimité par les faces respectives en regard du circuit intégré et de la feuille de support confère une tenue mécanique très supérieure à celle rencontrée avec les cartes sans contact de la technique antérieure.

De préférence, il est prévu deux plages conductrices et deux plages de compensation non connectées, disposées selon deux diagonales d'un rectangle en vue d'un appui direct du circuit intégré par ses quatre coins. En particulier, des spires de l'antenne de couplage passent entre des paires de plages adjacentes, en s'étendant sous le circuit intégré.

Selon une autre caractéristique très avantageuse de l'invention, le matériau adhésif comporte un point de colle simple ou double, et une résine de scellement occupant majoritairement l'espace laissé libre délimité par les faces respectives en regard de la feuille de support et du circuit intégré. La résine de scellement précitée améliore considérablement la tenue mécanique de l'ensemble. Ceci permet par suite, si on le souhaite, de sérigraphier l'antenne de couplage sur la feuille de support, et de prévoir des largeurs de piste plus importantes au niveau des connexions entre le circuit intégré et les plages sérigraphiées.

De préférence alors, au moins une des spires de l'antenne de couplage passant sous le circuit intégré présente une portion externe s'étendant en dehors de l'aplomb dudit circuit intégré. En particulier, deux spires de l'antenne de couplage sont concernées, et ces spires présentent des profils qui se correspondent dans une symétrie axiale dont le centre est sensiblement à l'aplomb du centre du circuit intégré, et les portions externes des deux spires forment deux arcs dont la concavité est tournée vers le centre de symétrie. Chacun des arcs précités permet de confiner une goutte de résine de scellement déposée à l'intérieur de leur concavité, lesdites gouttes s'étendant ensuite par capillarité dans l'espace libre délimité par les faces respectives en regard de la feuille de support et des circuits intégrés.

Conformément à un mode d'exécution particulier, on pourra prévoir que les plages de compensation non connectées présentent un appendice de retenue dirigé vers une spire de l'antenne de couplage passant sous le circuit intégré. Ces appendices permettent de former un étranglement lors de l'écoulement de la résine liquide sous le circuit intégré, améliorant ainsi la retenue et l'expansion de ladite résine liquide.

L'invention concerne également un procédé de fabrication d'une carte à mémoire du type précité, ledit procédé étant remarquable en ce qu'avant le laminage du corps de carte, on procède aux étapes successives suivantes :
a) réalisation, par gravage ou impression, sur une face de la feuille isolante de support, d'une antenne de couplage, de deux plages conductrices connectées à ladite antenne de couplage, et de deux plages de compensation non connectées, lesdites plages étant positionnées selon un rectangle correspondant au format du circuit intégré à mettre en place ;
b) mise en place du circuit intégré avec appui direct de deux de ses plots sur les plages conductrices, et interposition d'un matériau adhésif dans l'espace libre délimité par les faces en regard de la feuille de support et du circuit intégré.

De préférence, l'interposition de matériau adhésif comporte d'abord la réalisation d'un point de colle simple ou double pour former un lien mécanique entre la feuille de support et le circuit intégré, puis le dépôt sur la feuille de support, au voisinage du circuit intégré, d'au moins une goutte de résine de scellement à l'état fluide, ladite goutte s'étendant par capillarité dans l'espace laissé libre délimité par les faces respectives en regard.

Dans le cas particulier de spires présentant des arcs dont la concavité est tournée vers le centre de symétrie, on pourra prévoir qu'une goutte de résine de scellement est déposée à l'intérieur de la concavité de chacun de ces arcs.

D'autres caractéristiques et avantages de l'invention apparaîtront plus clairement à la lumière de la description qui va suivre, concernant un mode de réalisation particulier non limitatif de l'invention, en référence aux figures des dessins où :
- la figure 1 est une vue en perspective d'une carte sans contact conforme à l'invention, dont une partie de recouvrement a été enlevée afin de mieux distinguer l'agencement de l'antenne prévue sur une feuille de support associée, et surmontée d'un circuit intégré ;
- la figure 2 est une vue éclatée en perspective de la carte sans contact de la figure 1, avant le laminage des différentes épaisseurs du corps de carte de celle-ci ;
- les figures 3A et 3B sont des vues de dessus, à plus grande échelle, de la zone du circuit intégré en appui sur les quatre plages associées prévues sur la feuille de support, respectivement avant et après le dépôt d'une résine de scellement passant sous le circuit intégré ;
- les figures 4A et 4B sont des coupes selon IV-IV des figures 3A et 3B, permettant de mieux distinguer la disposition d'une résine de scellement dans l'espace libre délimité par les deux faces en regard de la feuille de support et du circuit intégré ;
- les figures 5 à 9 illustrent d'autres variantes en vue de dessus, de modes de pistage des spires de l'antenne de couplage au voisinage du circuit intégré, lequel circuit intégré est associé selon le cas par deux points de colle symétriques ou par un point de colle central unique.

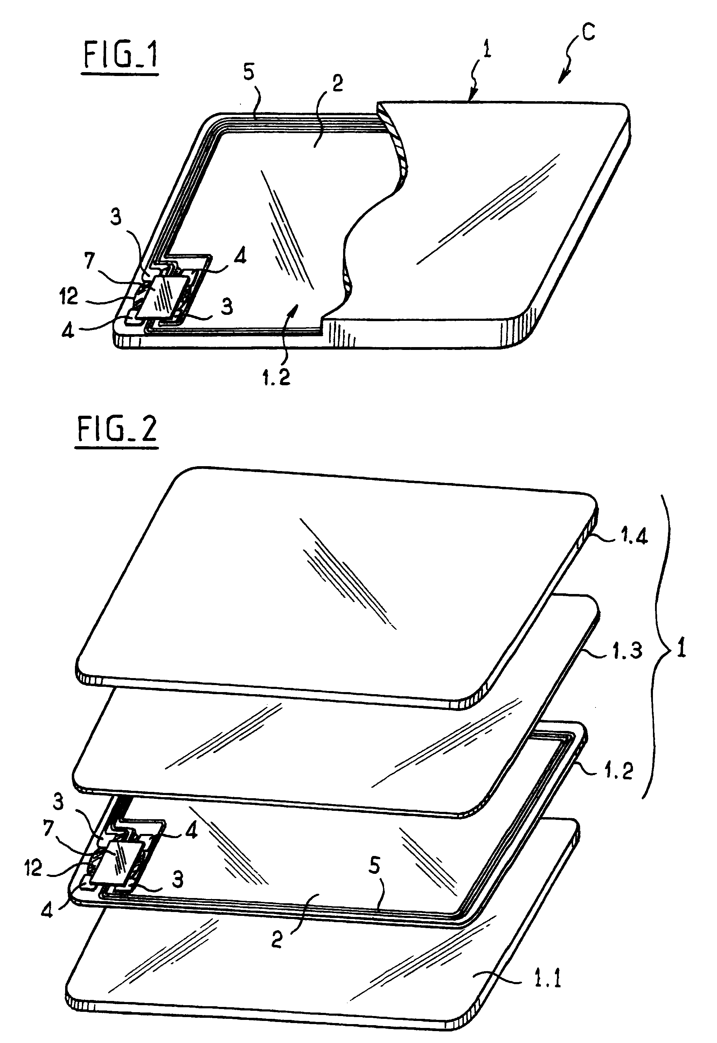

Sur la figure 1, on distingue une carte à mémoire C du type sans contact, comportant un corps de carte 1 en matière plastique, de type laminé. La figure 2 illustre l'empilement des différentes couches concernées constitutives du corps de carte laminé 1, avant le laminage de celui-ci : on distingue ainsi successivement une couche 1.1 de verso de la carte, une feuille de support 1.2, sur laquelle est disposée une antenne de couplage surmontée d'un circuit intégré, une feuille entretoise de compensation 1.3, et une couche 1.4 de recto de la carte.

La feuille de support 1.2 est ainsi prise en sandwich entre les autres épaisseurs formant le corps de carte, et sur une face notée 2 de cette feuille de support 1.2 est agencée une antenne de coulage 5 dont on distingue les différentes spires qui s'étendent tout autour de la périphérie de la feuille de support. Cette antenne de couplage 5 sera soit réalisée en cuivre, par une technique de gravage sous forme d'un dépôt sur feuille, soit par une technique d'impression par sérigraphie au moyen d'une encre conductrice. Ces techniques sont bien connues des spécialistes, de sorte qu'il est inutile de les décrire plus en détail. Les figures 1 et 2 permettent de distinguer également un circuit intégré 7 dont deux de ses plots de contact sont reliés à l'antenne de couplage 5. On a représenté de façon schématique sur la figure 1 différentes plages d'appui notées 3, 4 sur lesquelles repose le circuit intégré 7 : ainsi que cela sera décrit plus en détail plus loin en référence aux figures suivantes, les plages 3 sont des plages conductrices connectées à l'antenne de couplage 5, tandis que les plages 4 sont des plages supplémentaires de compensation non connectées à ladite antenne, de sorte que le circuit intégré 7 repose directement par ses quatre coins sur ces plages 3, 4. On distingue également les bords d'une épaisseur d'un matériau noté 12 qui est en fait une résine de scellement également présente sous le circuit intégré 7, dans l'espace libre délimité par les faces respectives en regard de la feuille de support 2 et du circuit intégré 7.

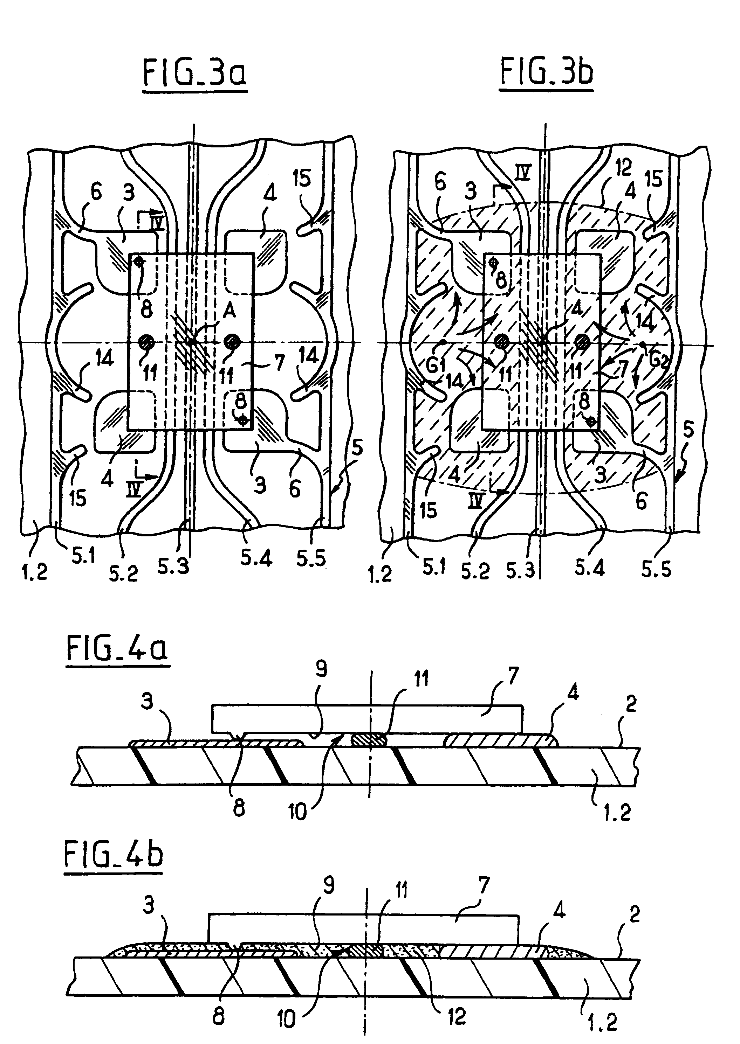

On va maintenant se référer au mode de réalisation illustré sur les figures 3A et 3B, et sur les coupes associées des figures 4A et 4B.

Conformément à une caractéristique de l'invention, il est prévu que le circuit intégré 7 repose directement par deux de ses plots de contact, notés 8, sur deux plages conductrices 3 connectées à l'antenne de couplage 5, en étant également en appui sur au moins une plage supplémentaire de compensation 4 non connectée à ladite antenne, pour s'étendre sensiblement parallèlement à la feuille de support 1.2, ledit circuit intégré et ladite feuille de support étant associés mécaniquement l'un à l'autre par un matériau adhésif agencé dans l'espace libre noté 10 délimité par les faces respectives en regard notées respectivement 9 pour la face inférieure du circuit intégré 7, et 2 pour la face supérieure de la feuille de support 1.2.

Les plages d'appui 3, 4 sur lesquelles repose le circuit intégré 7 servent ainsi à la fois à la connexion électrique du fait de l'appui direct des plots 8 sur les plages conductrices 3 connectées à l'antenne de couplage 5, mais aussi à l'appui mécanique permettant un positionnement précis de superposition du circuit intégré 7 au-dessus de la feuille de support 1.2. En l'espèce, on a prévu deux plages conductrices 3 connectées à l'antenne de couplage 5, et deux plages de compensation non connectées 4, disposées selon deux diagonales d'un rectangle en vue d'un appui direct du circuit intégré 7 par ses quatre coins. Le circuit intégré 7 repose ainsi par ses deux plots 8 sur les plages conductrices 3, et par ses deux autres coins sur les plages non connectées 4, en s'étendant sensiblement parallèlement à la feuille de support.

Du fait de l'appui direct du circuit intégré 7 sur ses quatre plages d'appui 3, 4, il est indispensable de prévoir un moyen de liaison fiable entre le circuit intégré 7 et la feuille de support 2. Par suite, un simple point de colle interposé entre les deux faces respectives en regard serait certainement insuffisant.

C'est pourquoi on a prévu, conformément à une caractéristique avantageuse de l'invention, que le matériau adhésif agencé dans l'espace 10 délimité par les faces respectives en regard 2, 9, comporte à la fois un point de colle simple ou double (double point de colle 11 sur les figures 3A à 4B), et une résine de scellement notée 12, qui occupe majoritairement l'espace 10 laissé libre délimité par les faces respectives en regard de la feuille de support 1.2 et du circuit intégré 7. Cette résine de scellement 12 constitue un pontage de liaison mécanique extrêmement fiable entre les deux surfaces en regard, et confère alors une excellente tenue mécanique du circuit intégré sur les plages de l'antenne de couplage, même en cas d'efforts de flexion ou de torsion importants exercés sur le corps de carte. Ainsi qu'on le verra par la suite, et conformément à un aspect important du procédé de fabrication de la carte sans contact selon l'invention, la résine de scellement est présente sous le circuit intégré 7 grâce à une insertion par capillarité entre les deux faces en regard lorsque cette résine est déposée sous forme de gouttes à des endroits convenables prédéterminés, à l'état fluide. On a en effet constaté, de façon tout à fait surprenante pour l'homme de métier, que la résine de scellement à l'état liquide pouvait se répandre de façon très favorable en présence d'un espace délimité par les deux faces parallèles en regard, alors que ce n'est pas le cas si la goutte de résine est simplement déposée en un point déterminé de la face de support non surmontée du circuit intégré.

A titre indicatif, on pourra utiliser une feuille de support 1.2 d'environ 250 µm d'épaisseur, par exemple en polychlorure de vinyle, avec sur cette feuille un motif spiralé en cuivre ou en encre conductrice déposée par sérigraphie (antenne de couplage 5), d'une épaisseur d'environ 35 µm. L'appui du circuit intégré 7 sur les plages conductrices 3 (par ses plots de contact 8) et les plages de compensation 4 définit un espace 10 délimité par deux plans parallèles dont la hauteur est alors de l'ordre de 85 µm : c'est cet espace qui est majoritairement occupé par la résine de scellement 12 précitée.

Ainsi que cela est visible sur les figures 3A et 3B, des spires de l'antenne de couplage 5 passent entre des paires de plages adjacentes 3, 4, en s'étendant sous le circuit intégré 7. En l'espèce, on a noté 5.1 à 5.5 les cinq spires constituant ici l'antenne de couplage 5, avec deux spires passant à l'extérieur de l'aplomb du circuit intégré 7, notées 5.1 et 5.5, et trois spires centrales 5.2, 5.3, 5.4 qui passent sous le circuit intégré 7. La liaison mécanique très fiable réalisée entre le circuit intégré et la feuille de support associée permet d'envisager des largeurs importantes de piste pour l'antenne de couplage, et plus particulièrement de choisir des largeurs de piste plus importantes au niveau des connexions entre le circuit intégré et les plages sérigraphiées. Ceci permet également d'augmenter le nombre de spires de l'antenne de couplage, et par suite la portée de l'antenne.

Sur les figures 3A et 3B, les plages conductrices 3 sont reliées aux spires extérieures 5.1 et 5.5 par des ligaments conducteurs notés 6, les plages 4 n'étant quant à elles aucunement reliées à ces spires, dans la mesure où elles ne sont pas connectées à l'antenne (il convient de rappeler que les plages 4 sont des plages de compensation d'épaisseur, dont la fonction essentielle est d'assurer un positionnement stable du circuit intégré au-dessus de la feuille de support).

Les figures 3A et 4A d'une part, et 3B et 4B d'autre part, permettent également de bien comprendre le procédé de fabrication de la carte à mémoire précitée.

Comme cela est visible sur la figure 3A, on commence par réaliser, par gravage où impression, sur la face 2 de la feuille isolante de support 1.2, une antenne de couplage 5, deux plages conductrices 3 connectées à l'antenne de couplage 5, et deux plages de compensation 4 non connectées, lesdites plages étant positionnées selon un rectangle correspondant au format du circuit intégré 7 à mettre en place. Ensuite, on met en place le circuit intégré 7 avec un appui direct de deux de ses plots 8 sur les plages conductrices 3, en interposant un matériau adhésif dans l'espace libre délimité par les faces en regard de la feuille de support 1.2 et du circuit intégré 7. Sur la figure 3, l'interposition de matériau adhésif est limitée à la réalisation d'un double point de colle 11 visant à constituer un lien mécanique entre la feuille de support 1.2 et le circuit intégré 7.

La figure 3B illustre l'étape complémentaire d'interposition de matériau adhésif, avec le dépôt, sur la feuille de support 1.2, d'au moins une goutte de résine de scellement à l'état fluide, ladite goutte s'étendant par capillarité dans l'espace laissé libre délimité par les surfaces respectives en regard. Dans la pratique, on déposera une goutte au voisinage du circuit intégré 7, de façon que cette goutte s'étende par sa fluidité, puis, grâce à un effet de capillarité, se propage dans l'espace libre délimité par les deux faces parallèles en regard, en passant sous le circuit intégré 7. Sur les figures 3A et 3B, on constate que les spires 5.1 et 5.5 présentent chacune une portion d'arc 14, la concavité de ces deux portions d'arc 14 étant tournée vers un point A qui est un centre de symétrie pour les profils constitutifs des spires de l'antenne de couplage 5. Le centre de symétrie A est sensiblement à l'aplomb du centre du circuit intégré 7. L'intérêt de cette configuration en forme d'arcs 14 est de délimiter deux zones de dépôt d'une goutte de résine de scellement à l'état liquide, les points de dépôt étant notés G1 et G2, les bords de la goutte étant alors encadrés, pour se propager entre les plages 3, 4, en passant sous la face inférieure 9 du circuit intégré 7. Les spires 5.1 et 5.5 pourront également présenter des béquets 15 dirigés vers la plage de compensation adjacente 4 correspondante, permettant de bien confiner les espaces de propagation de la résine de scellement à l'état fluide. Une fois que cette résine s'est répandue jusqu'à la limite conférée par sa tension superficielle, en rapport avec le matériau constitutif de la feuille de support, on constate que cette résine occupe majoritairement l'espace délimité entre les deux faces en regard du circuit intégré de la feuille de support. La zone d'expansion de la résine de scellement est illustrée schématiquement sur la figure 3B sous forme d'une zone hachurée dont le contour est indiqué en traits mixtes.

Sur les figures 3A et 3B, on constate que les trois spires centrales 5.2, 5.3, 5.4 s'étendent sur la feuille de support 1.2 en passant selon la direction longitudinale du circuit intégré 7. Dans ce cas, les tronçons des spires 5.2 et 5.4 occupent une partie de l'espace délimité entre les deux faces en regard, et par suite, lorsque la résine adhésive passe sur ces tronçons, l'épaisseur de celle-ci est relativement faible. La tenue mécanique est certes très bonne, mais il possible de concevoir d'autres modes d'exécution des profils de pistage de ces spires, afin de dégager plus d'espace disponible sur la face 2 de la feuille de support 1.2, qui est alors occupé par la pleine épaisseur de la résine de scellement intermédiaire. Ainsi que cela est aisé à comprendre, plus la résine de scellement occupe une surface importante dans cet espace intermédiaire, meilleure sera la tenue mécanique du circuit intégré.

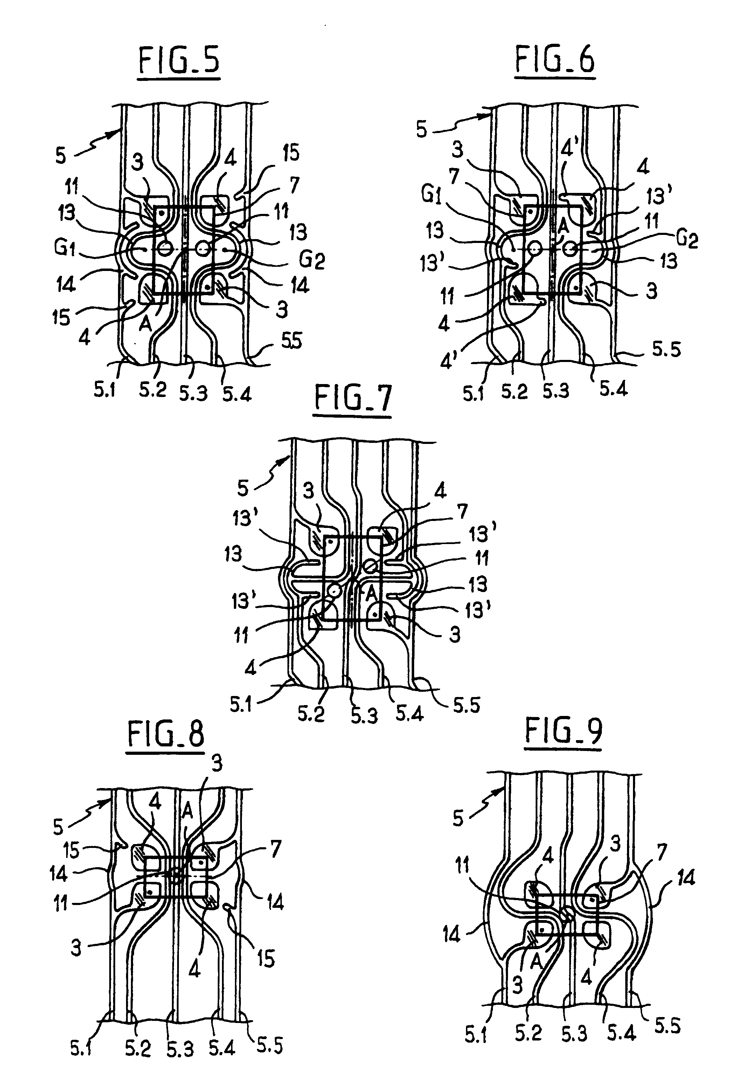

On a illustré sur les figures 5 à 9 d'autres modes de pistage des spires de l'antenne de couplage 5 qui permettent, conformément à l'approche précitée, d'augmenter la surface d'occupation, et par suite le volume disponible, pour la résine de scellement présente sous le circuit intégré 7.

Sur la figure 5, on constate que les pistes 5.2 et 5.4 s'incurvent autour des plages 3, 4, et présentent chacune une portion externe notée 13 s'étendant en dehors de l'aplomb du circuit intégré 7. Ces portions 13, en forme de demi-lune fermée, constituent un espace favorable pour la réception de deux gouttes de scellement aux points G1 et G2 qui vont alors se répandre sous le circuit intégré 7. La longueur des spires 5.2 et 5.4 passant sous le circuit intégré 7 et par suite devenue faible que dans le mode de réalisation précédent, ce qui augmente la surface disponible pour la présence de la résine intermédiaire de scellement. Les portions externes des deux spires 13 forment des arcs dont la concavité est tournée vers le centre de symétrie A.

Sur la figure 6, on est allé encore plus loin dans cette approche, dans la mesure où les spires 5.2 et 5.4 ne contournent que les plages conductrices associées 3 en passant sous le circuit intégré 7, ce qui libère encore plus de surface intermédiaire pour la résine de scellement. A l'extérieur de l'aplomb du circuit intégré 7, les spires 5.2, 5.4 présentent également des arcs 13, dont la concavité est tournée vers le centre de symétrie A, avec en outre des béquets terminant la forme en demi-lune, notés 13', la forme en demi-lune étant ici ouverte. Deux gouttes seront déposées aux points G1 et G2 comme précédemment, pour s'épandre sous le circuit intégré 7, avec une épaisseur maximum pour la résine de scellement sur une surface hachurée importante. On constate également sur la figure 6 la présence d'appendices 4' pour les plages de compensation non connectées 4. Ces appendices 4' sont dirigés vers la spire 5.3 de l'antenne de couplage 5 passant sous le circuit intégré 7, et définissent chacun un étranglement constituant un moyen de retenue de la résine lors de l'expansion de celle-ci à l'état fluide. Le passage préférentiel ainsi formé facilite la bonne répartition avec une homogénéité optimale pour la résine de scellement.

La figure 7 illustre une autre variante dans laquelle le double point de colle 11 est disposé en diagonale par rapport à la direction longitudinale du circuit intégré. On parvient ainsi à avoir une distance plus importante entre les deux points de colle 11. On constate en outre une forme légèrement différente pour les deux portions extérieures en demi-lune 13, dont les appendices 13' sont doublés, les forme en arcs 13 étant reliées en leur centre à la branche de spire associée 5.2 ou 5.4 qui débouche de l'aplomb du circuit intégré, perpendiculairement à la direction longitudinale de celui-ci.

La figure 8 illustre une autre variante d'exécution, dans laquelle le circuit intégré 7, en appui sur ses plages 3 et 4, est relié à la feuille de support 1.2 par un point de colle unique central 11, ce qui libère un espace important pour la résine de scellement occupant majoritairement l'espace délimité par les deux faces en regard.

La figure 9 illustre encore une autre variante, également à point unique de colle 11 au centre du circuit intégré 7, mais avec une conformation à contournement pour les spires 5.2 et 5.4, dans le même esprit que la variante illustrée sur la figure 6 précédemment décrite.

Les différents profils de pistage illustrés aux figures 5 à 9 ne constituent naturellement que des exemples non limitatifs, et il va de soi que l'on pourra prévoir encore de nombreuses autres variantes sans sortir du cadre de l'invention.

Il convient de noter que les différents profils qui ont été illustrés permettent de limiter les risques de coalescence dans le cas d'une antenne de couplage sérigraphiée sur la feuille de support, grâce à l'agencement favorable de la zone critique de la sérigraphie qui est la zone de connexion du circuit intégré, les bords de piste et de plage étant très proches les uns des autres.

L'invention n'est pas limitée au mode de réalisation qui vient d'être décrit, mais englobe au contraire toute variante reprenant, avec des moyens équivalents, les caractéristiques essentielles énoncées plus haut.

## Revendications

1. Carte à mémoire du type sans contact, comportant un corps de carte laminé en matière plastique (1) présentant une feuille de support (1.2) prise en sandwich, sur une face (2) de laquelle est agencée une antenne de couplage (5) ainsi qu'un circuit intégré (7) dont deux plots de contact (8) sont reliés à ladite antenne de couplage, caractérisée en ce que le circuit intégré (7) repose directement par les deux plots précités (8) sur deux plages conductrices (3) connectées à l'antenne de couplage (5), en étant également en appui sur au moins une plage supplémentaire de compensation (4) non connectée à ladite antenne, de façon à s'étendre sensiblement parallèlement à la feuille de support (1.2), ledit circuit intégré et ladite feuille de support étant associés mécaniquement l'un à l'autre par un matériau adhésif (11, 12) agencé dans l'espace libre (10) délimité par leurs faces respectives en regard (9, 2).

2. Carte à mémoire selon la revendication 1, caractérisée en ce qu'il est prévu deux plages conductrices (3) et deux plages de compensation non connectées (4), disposées selon deux diagonales d'un rectangle en vue d'un appui direct du circuit intégré (7) par ses quatre coins.

3. Carte à mémoire selon la revendication 2, caractérisée en ce que des spires (5.2, 5.3, 5.4) de l'antenne de couplage (5) passent entre des paires de plages adjacentes (3, 4), en s'étendant sous le circuit intégré (7) .

4. Carte à mémoire selon l'une des revendications 1 à 3, caractérisée en ce que le matériau adhésif (11, 12) comporte un point de colle simple ou double (11), et une résine de scellement (12) occupant majoritairement l'espace (10) laissé libre délimité par les faces respectives en regard de la feuille de support (1.2) et du circuit intégré (7) .

5. Carte à mémoire selon les revendications 3 et 4, caractérisée en ce qu'au moins une (5.2, 5.4) des spires de l'antenne de couplage (5) passant sous le circuit intégré (7) présente une portion externe (13) s'étendant en dehors de l'aplomb dudit circuit intégré.

6. Carte à mémoire selon la revendication 5, caractérisée en ce que deux spires (5.2, 5.4) de l'antenne de couplage (5) sont concernées, et ces spires présentent des profils qui se correspondent dans une symétrie axiale dont le centre (A) est sensiblement à l'aplomb du centre du circuit intégré (7) .

7. Carte à mémoire selon la revendication 5 ou la revendication 6, caractérisée en ce que les portions externes des deux spires forment deux arcs (13) dont la concavité est tournée vers le centre de symétrie (A).

8. Carte à mémoire selon l'une des revendications 5 à 7, caractérisée en ce que les plages de compensation non connectées (4) présentent un appendice de retenue (4') dirigé vers une spire (5.3) de l'antenne de couplage (5) passant sous le circuit intégré (7).

9. Procédé de fabrication d'une carte à mémoire selon l'une au moins des revendications 2 à 8, caractérisé en ce qu'avant le laminage du corps de carte (1) , on procède aux étapes successives suivantes :
a) réalisation, par gravage ou impression, sur une face (2) de la feuille isolante de support (1.2), d'une antenne de couplage (5), de deux plages conductrices (3) connectées à ladite antenne de couplage (5), et de deux plages de compensation (4) non connectées, lesdites plages étant positionnées selon un rectangle correspondant au format du circuit intégré (7) à mettre en place ;
b) mise en place du circuit intégré (7) avec appui direct de deux de ses plots (8) sur les plages conductrices (3), et interposition d'un matériau adhésif (11, 12) dans l'espace libre délimité par les faces en regard de la feuille de support (1.2) et du circuit intégré (7).

10. Procédé selon la revendication 9, caractérisé en ce que l'interposition de matériau adhésif comporte d'abord la réalisation d'un point de colle simple ou double (11) pour former un lien mécanique entre la feuille de support (1.2) et le circuit intégré (7), puis le dépôt sur la feuille de support (1.2), au voisinage du circuit intégré (7), d'au moins une goutte (G1, G2) de résine de scellement à l'état fluide, ladite goutte s'étendant par capillarité dans l'espace laissé libre délimité par les faces respectives en regard.

11. Procédé selon la revendication 10, pour fabriquer une carte à mémoire selon les revendications 5 à 7, caractérisé en ce qu'une goutte (G1, G2) de résine de scellement est déposée à l'intérieur de la concavité d'arcs (13, 14) formés par une portion de spires de l'antenne de couplage (5).
